# EUROPEAN PATENT APPLICATION

(11) **EP 2 661 165 A1**
(43) Date of publication of application: **06.11.2013**
(21) Application number: 12166363.7
(22) Date of filing: 02.05.2012
(51) Int. Cl.: H05K 7/20

(54) **Cooling assembly**

(71) Applicant: ABB Research Ltd., 8050 Zürich (CH)
(72) Inventor: Koivuluoma, Timo, 00380 Helsinki (FI); Agostini, Bruno, 00380 Helsinki (FI); Habert, Mathieu, 00380 Helsinki (FI); Siirilä, Jouko, 00380 Helsinki (FI)
(74) Representative: Kolster Oy Ab

(57) **Abstract**

A cooling assembly comprising a device chamber (2), a cooling chamber (4), heat exchanger means, fan means and control means (6), the heat exchanger means comprising a first heat exchanger unit (31) and a second heat exchanger unit (32) located above the first heat exchanger unit (31), the fan means comprising a first fan (52) adapted to generate a first cooling air flow (521). The cooling assembly further comprises a first dust tray (72) located between the first heat exchanger unit (31) and the second heat exchanger unit (32), the first cooling air flow (521) being directed towards the first dust tray (72), the first dust tray (72) being adapted to receive and retain at least part of contaminant particles present in the first cooling air flow (521), the device chamber (2) being separated from the cooling chamber (4).

## Description

### FIELD OF THE INVENTION

The present invention relates to a cooling assembly according to a preamble of claim 1.

One of the problems associated with known cooling assemblies is clogging of heat exchanger means due to contaminant particles present in cooling air flow.

### BRIEF DESCRIPTION OF THE INVENTION

An object of the present invention is to provide a cooling assembly so as to alleviate the above mentioned clogging problem. The objects of the invention are achieved by a cooling assembly which is characterized by what is stated in the independent claim. The preferred embodiments of the invention are disclosed in the dependent claims.

The invention is based on the idea of providing a cooling assembly with a first dust tray located in the vertical direction between a first heat exchanger unit and a second heat exchanger unit, the first dust tray being adapted to receive and retain at least part of contaminant particles present in a first cooling air flow generated by a first fan and directed towards the first dust tray.

An advantage of the cooling assembly of the invention is that risk of clogging of heat exchanger units is reduced.

### BRIEF DESCRIPTION OF THE DRAWINGS

In the following the invention will be described in greater detail by means of preferred embodiments with reference to the attached drawings, in which
Figure 1 is shows a cooling assembly according to an embodiment of the invention;
Figure 2 shows the cooling assembly of Figure 1 during an automatic cleaning operation; and
Figure 3 shows the cooling assembly of Figure 1 with a first pivotable portion in a cleaning position.

### DETAILED DESCRIPTION OF THE INVENTION

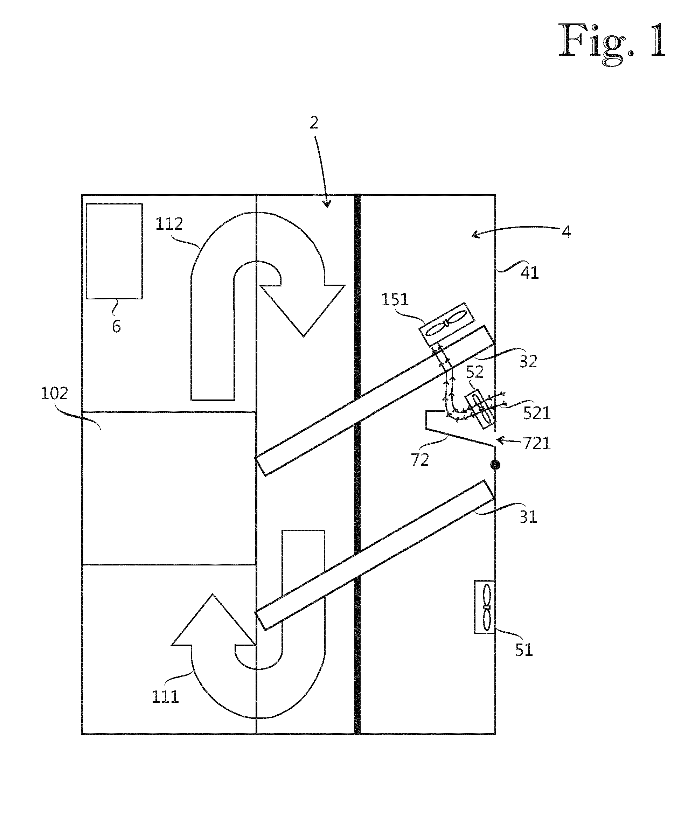

Figure 1 is shows a cooling assembly comprising a device chamber 2, a cooling chamber 4, heat exchanger means, fan means, a first dust tray 72 and control means 6 for controlling the fan means. Figure 1 shows the cooling assembly during cooling operation.

The heat exchanger means are adapted to transfer heat from the device chamber 2 to the cooling chamber 4. The heat exchanger means comprise a first heat exchanger unit 31 and a second heat exchanger unit 32 located above the first heat exchanger unit 31. The first heat exchanger unit 31 and the second heat exchanger unit 32 are spaced apart in the vertical direction.

Each of the first 31 and second 32 heat exchanger units comprise a first end located in the device chamber 2, and a second end located in the cooling chamber 4. Each of the heat exchanger units is tilted such that the first end is substantially lower than the second end. The device chamber 2 is separated from the cooling chamber 4 such that there is substantially no air flow between the device chamber 2 and the cooling chamber 4. Therefore substantially no contaminant particles can pass from the cooling chamber 4 into the device chamber 2.

There is a heat generating apparatus 102 in the device chamber 2. The heat generating apparatus 102 is an apparatus that requires cooling. The heat generating apparatus 102 may comprise for example a frequency converter or inverter. An arrow 112 illustrates a hot air flow from the heat generating apparatus 102 towards the first ends of the first heat exchanger unit 31 and second heat exchanger unit 32. An arrow 111 illustrates a cooled air flow from the first ends of the first heat exchanger unit 31 and second heat exchanger unit 32 towards the heat generating apparatus 102.

The fan means comprise a first fan 52 adapted to generate a first cooling air flow 521 from ambient air to the cooling chamber 4 between the first heat exchanger unit 31 and the second heat exchanger unit 32. The first fan 52 is also adapted to transfer heat from the cooling chamber 4 to ambient air during the cooling operation. Heat is transferred from the cooling chamber 4 to ambient air due to an overpressure above the second heat exchanger unit 32. An air flow from the cooling chamber 4 to ambient air is not depicted in Figure 1, and nor is a discharge opening through which the air flow passes.

In an embodiment there is a filter in front of the first fan. The filter is located such that a first cooling air flow passes through the filter before passing through the first fan. The filter may comprise a coarse filter.

The first dust tray 72 is located between the first heat exchanger unit 31 and the second heat exchanger unit 32. The first cooling air flow 521 is directed towards the first dust tray 72, and the first dust tray 72 is adapted to receive and retain at least part of contaminant particles present in the first cooling air flow 521.

The first dust tray 72 is formed as an air guide adapted to guide the first cooling air flow 521 towards the second heat exchanger unit 32 substantially in vertical direction. Consequently the first cooling air flow 521 confronts a lower surface of the second heat exchanger unit 32 in a point located above the first dust tray 72. Therefore any contaminant particles falling off the first cooling air flow 521 before the second heat exchanger unit 32 is likely to land in the first dust tray 72, and not on the first heat exchanger unit 31. Consequently the first heat exchanger unit 31 remains clean and maintains its cooling capacity.

The first fan 52 is tilted downwards in order to direct the first cooling air flow 521 sloping downwards towards the first dust tray 72. An angle of the first fan 52 relative to the vertical direction is approximately 45°. In an alternative embodiment the first fan itself is not tilted but the first cooling air flow is deflected downwards by a suitable deflector.

The first dust tray 72 is located in a front portion of the cooling chamber 4, the front portion being removed from the device chamber 2 and adjacent to an exterior wall 41 of the cooling chamber 4. A bottom wall of the first dust tray 72 is inclined towards the exterior wall of the cooling chamber 4. The inclination both guides the first cooling air flow 521 and facilitates slipping of contaminant particles into a front portion of the first dust tray 72. An outermost end of the first dust tray 72 is bent back towards the exterior wall 41 of the cooling chamber 4 in order to prevent the first cooling air flow 521 from blowing contaminant particles out of the first dust tray 72. There is a discharge opening 721 in the exterior wall 41 of the cooling chamber 4, the discharge opening 721 communicating with the first dust tray 72 and being adapted to allow at least part of contaminant particles retained in the first dust tray 72 to fall out of the cooling chamber 4.

A width of the first dust tray 72 is substantially equal to a width of the cooling chamber 4. Further, a width of each of the first heat exchanger unit 31 and the second heat exchanger unit 32 is substantially equal to a width of the cooling chamber 4. Herein, a width direction is a direction perpendicular to the image plane of Figure 1.

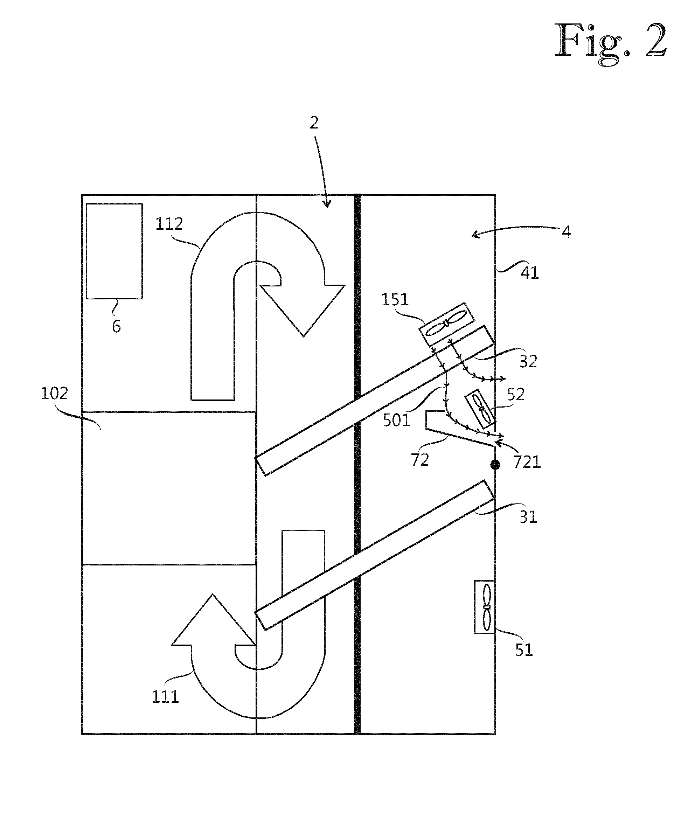

The control means 6 are adapted to provide an automatic cleaning operation which is shown in Figure 2. During the automatic cleaning operation a first cleaning air flow 501 is generated from the cooling chamber 4 to the ambient air, the first cleaning air flow 501 being substantially opposite to the first cooling air flow 521.

The fan means further comprise a bottom fan 51 and a first cleaning fan 151. The bottom fan 51 is adapted to run during the cooling operation. The bottom fan 51 is located in a bottom part of the cooling chamber 4, below the first heat exchanger unit 31. The bottom fan 51 is adapted to generate an air flow from the ambient air to the bottom part of the cooling chamber 4. A part of the air flow generated by the bottom fan 51 reaches the second heat exchanger unit 32 after passing through the first heat exchanger unit 31 and through a space between the first dust tray 72 and the device chamber 2. An air flow from the bottom part to an upper part of the cooling chamber 4 passes through the first heat exchanger unit 31 and the second heat exchanger unit 32.

In the embodiment shown in Figure 1 there is no dust tray below the bottom fan 51 since there is no heat exchanger unit below the bottom fan 51. Contaminant particles falling off the air flow of the bottom fan 51 land on a bottom wall of the cooling chamber 4 without hindering operation of the heat exchanger means. In an alternative embodiment there is a dust tray below a bottom fan located below a lowest heat exchanger unit, the dust tray being adapted to receive and retain at least part of contaminant particles present in the air flow generated by the bottom fan, thereby preventing said contaminant particles from proceeding to the lowest heat exchanger unit.

The first cleaning fan 151 is located above the second heat exchanger unit 32 and adapted to generate a first cleaning fan air flow directed towards an upper surface of the second end of the second heat exchanger unit 32. In the embodiment of Figure 2 the first cleaning fan air flow forms the entire first cleaning air flow 501 while the first fan 52 and the bottom fan 51 are turned off. In an alternative embodiment the first cleaning air flow is provided at least partially with the first fan by reversing the rotational direction of the first fan. It should also be noted that some contaminant particles fall off the second heat exchanger unit 32 simply due to turning off the first fan 52.

The first cleaning air flow 501 releases contaminant particles from the second heat exchanger unit 32, and particularly from a bottom surface of the second heat exchanger unit 32. The first cleaning air flow 501 carries the contaminant particles from the second heat exchanger unit 32 into the first dust tray 72 or directly into the ambient air through air intake of the first fan 52, the air intake being a structure through which the first fan 52 sucks cooling air from the ambient air during the cooling operation. The first cleaning air flow 501 also facilitates expulsion of contaminant particles from the first dust tray 72 out of the cooling chamber through the discharge opening 721.

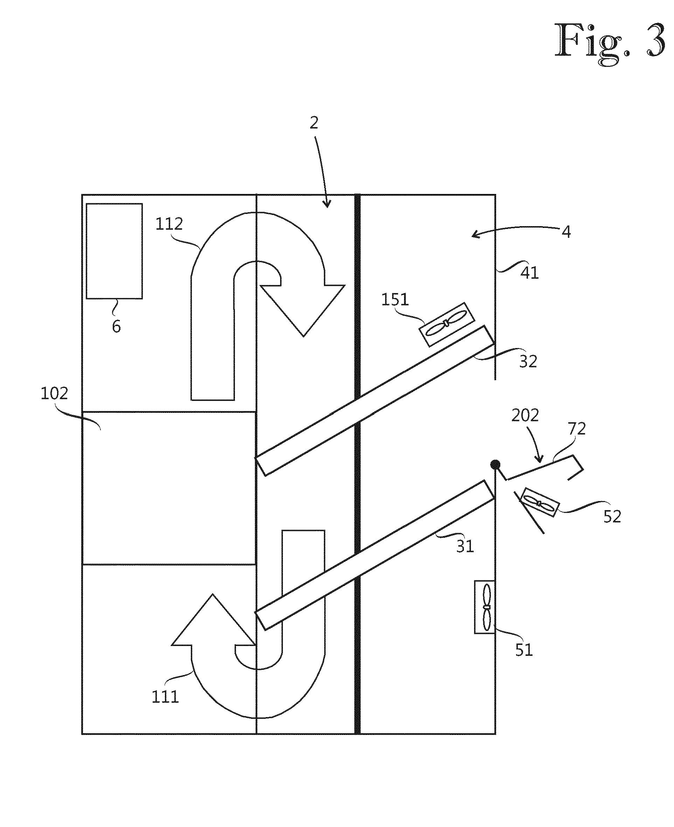

The cooling assembly further comprises a first pivotable portion 202 adapted to pivot with relation to the cooling chamber 4 between a use position and a cleaning position. The first dust tray 72 and the first fan 52 are mounted on the first pivotable portion 202. In Figures 1 and 2 the first pivotable portion 202 is in the use position and in Figure 3 the first pivotable portion 202 is in the cleaning position. The cleaning position of the first pivotable portion 202 is adapted for dumping contaminant particles retained in the first dust tray 72 out of the cooling chamber 4. Removal of contaminant particles may be facilitated for example by brushing or vacuum-cleaning. Further, the cleaning position of the first pivotable portion 202 may also be used for cleaning the first fan 52, and/or cleaning an upper surface of the first heat exchanger unit 31 and a lower surface of the second heat exchanger unit 32.

Figure 3 shows that in the cleaning position of the first pivotable portion 202 the first dust tray 72 is substantially upside down such that a normal vector of the inner bottom wall of the first dust tray 72 is in an acute angle of approximately 20° relative to the vertical direction. Therefore in the cleaning position a certain amount of contaminant particles normally fall out of the first dust tray 72 due to mere gravity.

Herein contaminant particles are any particles or objects that could impede operation of the heat exchanger means. The contaminant particles may comprise sand, dust, dirt, or pieces of plants such as leafs. The contaminant particles may also comprise litter such as candy wrappings.

The cooling assembly shown in Figures 1 to 3 has two heat exchanger units. An alternative embodiment may comprise three or more heat exchanger units spaced apart in vertical direction. For each pair of adjacent heat exchanger units there is a dust tray between the adjacent heat exchanger units. Further, there is a fan for each pair of adjacent heat exchanger units adapted to generate a cooling air flow from ambient air to the cooling chamber between the adjacent heat exchanger units, the cooling air flow being directed towards the dust tray, the dust tray being adapted to receive and retain at least part of contaminant particles present in the cooling air flow.

In the embodiment shown in the Figures the heat exchanger units are compact thermosyphon heat exchangers. In alternative embodiments different types of heat exchangers may be used.

It will be obvious to a person skilled in the art that the inventive concept can be implemented in various ways. The invention and its embodiments are not limited to the examples described above but may vary within the scope of the claims.

## Claims

1. A cooling assembly comprising a device chamber (2), a cooling chamber (4), heat exchanger means, fan means and control means (6), the heat exchanger means comprising a first heat exchanger unit (31) and a second heat exchanger unit (32) located above the first heat exchanger unit (31), each of the first (31) and second (32) heat exchanger units comprising a first end located in the device chamber (2), and a second end located in the cooling chamber (4), the heat exchanger means being adapted to transfer heat from the device chamber (2) to the cooling chamber (4), the fan means comprising a first fan (52) adapted to generate a first cooling air flow (521) from ambient air to the cooling chamber (4) between the first heat exchanger unit (31) and the second heat exchanger unit (32), and the control means (6) being adapted to control the fan means, **characterized in that** the cooling assembly further comprises a first dust tray (72) located between the first heat exchanger unit (31) and the second heat exchanger unit (32), the first cooling air flow (521) being directed towards the first dust tray (72), the first dust tray (72) being adapted to receive and retain at least part of contaminant particles present in the first cooling air flow (521), the device chamber (2) being separated from the cooling chamber (4).

2. A cooling assembly according to claim 1, **characterized in that** the first dust tray (72) is formed as an air guide adapted to guide the first cooling air flow (521) towards the second heat exchanger unit (32).

3. A cooling assembly according to claim 2, **characterized in that** the first dust tray (72) is adapted to guide the first cooling air flow (521) towards the second heat exchanger unit (32) substantially in vertical direction.

4. A cooling assembly according to any one of claims 1 to 3,
**characterized in that** the fan means are adapted to direct the first cooling air flow (521) sloping downwards towards the first dust tray (72).

5. A cooling assembly according to any one of preceding claims,
**characterized in that** the first dust tray (72) is located in a front portion of the cooling chamber (4), the front portion being removed from the device chamber (2) and adjacent to an exterior wall (41) of the cooling chamber (4).

6. A cooling assembly according to claim 5, **characterized in that** a bottom wall of the first dust tray (72) is inclined towards the exterior wall (41) of the cooling chamber (4).

7. A cooling assembly according to claim 6, **characterized in that** there is a discharge opening (721) in the exterior wall (41) of the cooling chamber (4), the discharge opening (721) communicating with the first dust tray (72) and being adapted to allow at least part of contaminant particles retained in the first dust tray (72) to fall out of the cooling chamber (4).

8. A cooling assembly according to any one of preceding claims,
**characterized in that** the cooling assembly further comprises a first pivotable portion (202) adapted to pivot with relation to the cooling chamber (4) between a use position and a cleaning position, the first dust tray (72) being mounted on the first pivotable portion (202).

9. A cooling assembly according to claim 8, **characterized in that** also the first fan (52) is mounted on the first pivotable portion (202).

10. A cooling assembly according to any one of preceding claims,
**characterized in that** a width of the first dust tray (72) is substantially equal to a width of the cooling chamber (4).

11. A cooling assembly according to any one of preceding claims,
**characterized in that** the control means (6) are adapted to provide an automatic cleaning operation during which a first cleaning air flow (501) is generated from the cooling chamber (4) to the ambient air, the first cleaning air flow (501) being substantially opposite to the first cooling air flow (521).

12. A cooling assembly according to claim 11, characteri z e d in that the fan means further comprise a first cleaning fan (151) located above the second heat exchanger unit (32) and adapted to generate a first cleaning fan air flow directed towards an upper surface of the second end of the second heat exchanger unit (32), wherein the first cleaning fan air flow forms at least part of the first cleaning air flow (501).

13. A cooling assembly according to claim 11 or 12, **characterized in that** the first cleaning air flow (501) is provided at least partially with the first fan (52) by reversing the rotational direction of the first fan (52).
